# EUROPÄISCHE PATENTSCHRIFT

(11) **EP 0 463 206 B1**
(45) Veröffentlichungstag und Bekanntmachung des Hinweises auf die Patenterteilung: **24.08.1994**
(21) Anmeldenummer: 90112138.4
(22) Anmeldetag: 26.06.1990
(51) Int. Cl.: G01R 25/08

(54) **Verfahren zum Messen kleiner Phasendifferenzen und Schaltungsanordnung zur Durchführung des Verfahrens**
Measuring process for small phase differences and circuit for applying this process
Procédé pour mesurer des petites différences de phase et circuit pour appliquer ce procédé

(43) Veröffentlichungstag der Anmeldung: 02.01.1992
(73) Patentinhaber: SIEMENS AKTIENGESELLSCHAFT, 80333 München (DE)
(72) Erfinder: Kramer, Ronalf, Dipl.-Ing., D-8000 München 60 (DE); Preller, Peter, Dipl.-Ing., D-8000 München 60 (DE)

(56) Entgegenhaltungen:
- EP-A- 0 122 491
- EP-A- 0 225 396
- PATENT ABSTRACTS OF JAPAN, Band 7, Nr. 206 (P-222)[1351], 10. September 1983;& JP-A-58 102 169 (NIPPON DENKI) 17-06-1983
- ELECTRONICS, Band 46, Nr. 26, 20. Dezember 1973, Seite 119; D.K. KOSTOPOULOS:"Digital logic circuit reads phase difference"

## Beschreibung

Die Erfindung betrifft ein Verfahren zum Messen kleiner Phasendifferenzen zwischen einem Istimpuls und einem Referenzimpuls.

In Phasenregelkreisen, auch PLLs genannt, kann es notwendig sein im dortigen Phasendetektor auch Phasendifferenzen zu erfassen, die kleiner als eine Periodendauer der vom Phasenregelkreis gelieferten Taktfrequenz sind.

Beispielsweise wird bei der Verarbeitung von Fernsehsignalen der Systemtakt aus einem Horizontal-Synchronsignal mit einem digitalen Phasenregelkreis abgeleitet. Kann die Phasendifferenz im Phasenregelkreis aber nur auf eine Periodendauer der Taktfrequenz des Phasenregelkreises genau erfaßt werden, so machen sich deutlich sichtbare Bildstandschwankungen bemerkbar. Besonders störend wird dies bei der Einblendung eines Kleinbildes in ein Großbild. Durch die Ungenauigkeit der Phasendifferenzmessung im Phasendetektor des Phasenregelkreises, die wie ein Phasenjitter am Eingang des Phasenregelkreises wirkt und demzufolge einen Phasenjitter am Ausgang des Phasenregelkreises verursacht, zittert das eingeblendete Kleinbild in horizontaler Richtung.

Um die Störung so gering wie möglich zu halten, ist es notwendig den unerwünschten Phasenjitter so klein wie möglich zu machen. Damit ist es aber erforderlich Phasendifferenzen im Phasendetektor eines Phasenregelkreises zu erfassen, die kleiner als die Periodendauer des Ausgangstaktsignales des Phasenregelkreises sind.

Ein Verfahren zum Bestimmen solch kleiner Phasendifferenzen ist beispielsweise aus der DE 33 10 581 A1 bekannt. Dort wird die zwischen zwei Impulsen auftretende Phasendifferenz dadurch erfaßt, daß ein Impuls zunächst einem analogen Tiefpaß und anschließend einem Analog/Digital-Wandler zugeführt wird. Der Analog/Digital-Wandler tastet das Eingangssignal mit einer Taktfrequenz ab, die mit dem anderen Impuls verkoppelt ist. Die Ausgangssignale des Analog/Digital-Wandlers werden einem Multiplizierer mit den Koeffizienten +1 oder -1 zugeführt, wobei die Umschaltung dieser Koeffizienten durch den ersten Impuls erfolgt. Das Ausgangssignal des Multiplizierers wird dann einem digitalen Integrator zugeführt. Die Phasendifferenz wird schließlich durch Abtastung des Integratorausgangs bestimmt.

Damit ist das Ergebnis der digitalen Integration ein Maß für die Phasendifferenz zwischen den beiden Impulsen. Problematisch bei diesen bekannten Verfahren ist der doch relativ hohe Aufwand, der mit zunehmender Genauigkeit der Differenzmessung noch ansteigt, da die Auflösung des Analog/Digital-Wandlers erhöht werden muß. Darüber hinaus ist auch ein analoger Tiefpaß notwendig, der Schaltungskonzepten mit rein digitalen Lösungen entgegensteht.

Der Erfindung liegt die Aufgabe zugrunde, ein Verfahren zur Messung kleiner Phasendifferenzen anzugeben, daß die obengenannten Nachteile nicht aufweist. Darüber hinaus soll eine Schaltungsanordnung zur Durchführung des Verfahrens angegeben werden.

Die Aufgabe für das Verfahren wird durch die kennzeichnenden Merkmale des Anspruches 1 gelöst.

Weiterbildungen dieses Verfahrens sind Gegenstand der Ansprüche 2 bis 4.

Eine Schaltungsanordnung zur Durchführung des Verfahrens weist die Merkmale des Anspruchs 5 auf, deren Weiterbildungen in den Ansprüchen 6 und 7 angegeben sind.

Eine Verwendung des erfindungsgemäßen Verfahrens ist Gegenstand des Anspruchs 8 und 9.

Die Erfindung wird im folgenden anhand von fünf Figuren näher erläutert. Es zeigen:
- FIG 1: einen prinzipiellen Aufbau eines digitalen Phasenregelkreises,
- FIG 2: ein Blockschaltbild eines Phasendetektors mit jeweils einer Einrichtung zur Grobphasenmessung und Feinphasenmessung,
- FIG 3: beispielhaft einen Phasenunterschied zwischen einem Istimpuls und einem Referenzimpuls,
- FIG 4: eine Schaltungsanordnung zum Messen kleiner Phasendifferenzen mit einer Laufzeitkette nach der Erfindung und
- FIG 5: eine Schaltungsanordnung nach FIG 4 mit fünf Beispielen von in der Laufzeitkette festgehaltenen Istimpulsen zum Bestimmen der Phasendifferenz.

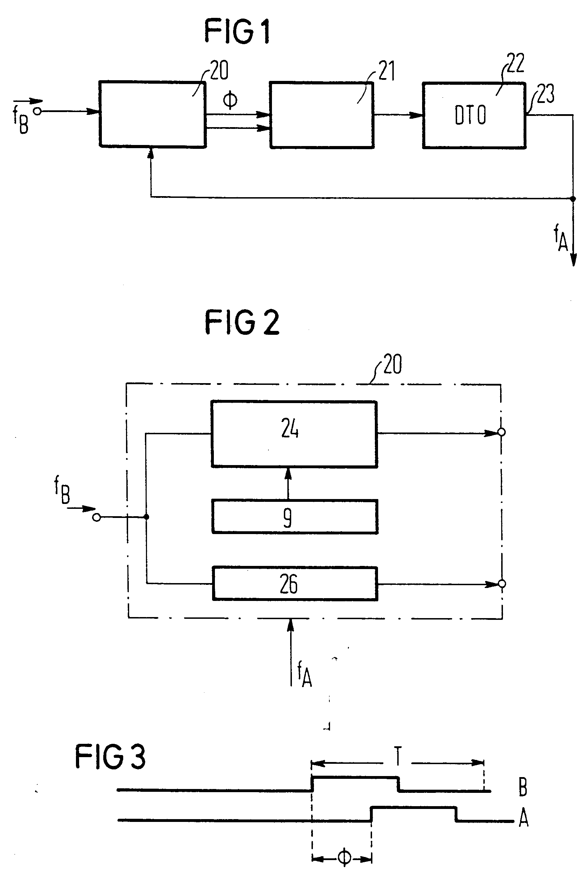

FIG 1 zeigt den prinzipiellen Aufbau eines digitalen Phasenregelkreises, wie dieser beispielsweise zur Taktableitung aus einem Horizontalsynchronsignal bei Fernsehgeräten verwendet wird. Der digitale Phasenregelkreis weist einen digitalen Phasendetektor 20 mit nachgeschaltetem digitalen Filter 21 sowie einen digital gesteuerten Oszillator (DTO-discret time oscillator) 22 auf, an dessen Ausgangsklemme 23 das Taktsignal f_{A} des Phasenregelkreises abgreifbar ist. Neben diesem Taktsignal f_{A} wird dem digitalen Phasendetektor 20 auch ein Referenztaktsignal f_{B}, beispielsweise das Horizontalsynchronsignal des Fernsehsignals,zugeführt. Bei einer auftretenden Phasen- und Frequenzabweichung zwischen dem Referenztaktsignal f_{B} und dem Taktsignal f_{A} regelt sich der digitale Phasenregelkreis so nach, daß der Phasen- oder Frequenzunterschied minimal wird. Der digitale Phasendetektor 20 liefert dabei ein Ausgangssignal, das durch die Phasenverschiebung zwischen dem Referenztaktsignal f_{B} und dem Taktsignal f_{A} bestimmt wird und als Regelgröße für den Phasenregelkreis dient. Um die Phasendifferenz 0̸ genau zu erfassen, wird im digitalen Phasendetektor 20 eine Einrichtung 24 zur Feinphasenmessung für kleine Phasendifferenzen 0̸ und eine Einrichtung 26 zur Grobphasenmessung vorgesehen, wie diese in FIG 2 dargestellt sind. Die Messung kleiner Phasendifferenzen 0̸ wird gemäß der Erfindung erst dann aktiviert, wenn die Grobphasenmessung mit der Auflösung einer Periodendauer T des Taktsignales f_{A} einen vorgegebenen Phasendifferenzwert, beispielsweise eine Periodendauer T des Taktsignales f_{A}, unterschreitet. Für die Grobphasenmessung können die bereits bekannten digitalen Verfahren zur Phasenmessung herangezogen werden, so daß auf diese hier im einzelnen nicht mehr eingegangen zu werden braucht.

Hat der von der Einrichtung 26 zur Grobphasenmessung erfaßte Phasendifferenzwert einen vorgegebenen Wert unterschritten, so wird über eine Steuereinrichtung 9 die Einrichtung 24 zur Feinphasenmessung aktiviert, die in der Lage ist, auch Phasendifferenzen 0̸ zu erfassen, die kleiner als eine Periodendauer T des Taktsignales f_{A} sind. Einen solchen Phasenunterschied 0̸ zeigt beispielsweise FIG 3, in der B einen vom Referenztaktsignal f_{B} abgeleiteten Referenzimpuls und A einen vom Taktsignal f_{A} abgeleiteten Istimpuls bezeichnet. Der Istimpuls A eilt in diesem Ausführungsbeispiel dem Referenzimpuls B nach, so daß sich eine positive Phasendifferenz 0̸ von hier 1/3 T ergibt, wenn die Phasen der beiden Impulse A und B hier beispielhaft durch die jeweils ansteigenden Flanken bestimmt ist.

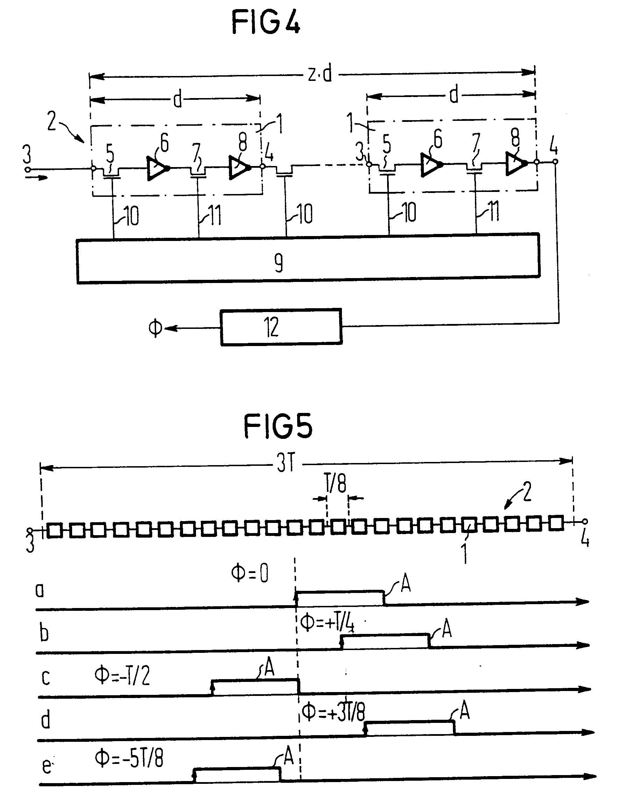

Gemäß der Erfindung weist die Einrichtung 24 zur Feinphasenmessung eine Schaltungsanordnung auf, wie diese in FIG 4 dargestellt ist. Im einzelnen zeigt FIG 4 eine Laufzeitkette 2 mit z hintereinandergeschalteten Laufzeitgliedern 1 mit je einer Laufzeit d . Die Gesamtlaufzeit der Laufzeitkette 2 ist damit z . d. Zwischen jede Eingangsklemme 3 und Ausgangsklemme 4 jedes Laufzeitgliedes 1 ist die Reihenschaltung einer Laststrecke eines ersten Transistors 5, eines ersten Inverters 6, eine Laststrecke eines zweiten Transistors 7 sowie ein zweiter Inverter 8 angeordnet, wobei die Steueranschlüsse der ersten und zweiten Transistoren 5, 7 mit einer Steuereinrichtung 9 verbunden sind.

An die Ausgangsklemme 4 des letzten Laufzeitgliedes 1 ist eine digitale Auswerteschaltung 12 geschaltet, an der der digitale Phasendifferenzmeßwert 0̸ abgreifbar ist.

Die Steuereinrichtung 9 ist so ausgebildet, daß sie einerseits die ersten und zweiten Transistoren 5 und 7 gemeinsam einschalten und andererseits die ersten und zweiten Transistoren 5, 7 abwechselnd einschalten kann, so daß ein in den Laufzeitgliedern 1 gespeicherter Impuls nach Art eines Schieberegisters aus der Laufzeitkette 2 herausgeschoben werden kann.

Das Verfahren zum Messen kleiner Phasendifferenzen 0̸ zwischen dem Istimpuls A und dem Referenzimpuls B sieht vor, daß der Istimpuls A zunächst an die Eingangsklemme 3 des ersten Laufzeitgliedes 1 gelegt wird und sämtliche Transistoren 5 und 7 durch die Steuereinrichtung 9 eingeschaltet sind. Damit läuft der Istimpuls A in die Laufzeitkette 2 solange hinein, bis nach Maßgabe eines Steuersignales der Istimpuls A in der Laufzeitkette 2 festgehalten wird. Das Steuersignal wird dabei von der Steuereinrichtung 9 geliefert. Anschließend wird die Lage des Istimpulses A in der Laufzeitkette 2 durch von der Steuereinrichtung 9 taktgesteuertes Herausschieben ermittelt. Die Anzahl der dabei noch zu durchlaufenden Laufzeitglieder 1 bestimmt die Phasendifferenz 0̸, die von der Auswerteschaltung 12 erfaßt wird. Die so ermittelte Phasendifferenz 0̸ ist also mit der Genauigkeit der Laufzeit d eines Laufzeitgliedes 1 aufgelöst. T bezeichnet die Periodendauer des vom Phasenregelkreis gelieferten Taktsignales f_{A}. Bei einer maximalen Laufzeit d des Laufzeitgliedes 1 von 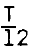 einer mittleren Laufzeit von 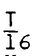 und einer min. Laufzeit von 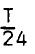 sollte die Länge der Laufzeitkette 2 so bemessen sein, daß Phasendifferenzen 0̸ bis zu ± 1,5 Periodendauern T gemessen werden können. Das Steuersignal zum Festhalten des in die Laufzeitkette 2 einlaufenden Istimpulses A wird dabei so gewählt, daß bei einer Phasendifferenz 0̸ = 0 und mittleren Laufzeit d dieser Impuls genau hinter einem vorgegebenen, z. B. dem 24. Laufzeitelement der Laufzeitkette 2 festgehalten wird.

Das Prinzip der Erfindung wird in FIG 5 anhand eines Ausführungsbeispieles mit einer Laufzeitkette 2 vorgestellt, die eine mittlere Gesamtlaufzeit 3T und insgesamt 24 Laufzeitglieder 1 mit jeweils einer Laufzeit von T/8 aufweist.

FIG 5a zeigt den Istimpuls A wie er in der Laufzeitkette 2 festgehalten wird, wenn keine Phasendifferenz zum Referenzimpuls B besteht. Der Istimpuls A wird hierbei gemäß der Erfindung in der Mitte der Laufzeitkette 2 nach Maßgabe eines beispielsweise vom Referenzsignal B abgeleiteten Steuersignales festgehalten. Dabei ist es notwendig, daß die Laufzeit d der einzelnen Laufzeitglieder 1 sowie die Länge z der Laufzeitkette 2 genau aufeinander abgestimmt sind. Beim Herausschieben des Istimpulses A aus der Laufzeitkette 2 stellt die bereits oben erwähnte Auswerteschaltung 12 fest, daß insgesamt noch 12 Laufzeitglieder 1 durchlaufen werden müssen, damit die positive Flanke des Istimpulses A an der Ausgangsklemme 4 der Laufzeitkette 2 erscheint, was in diesem Ausführungsbeispiel gleichbedeutend mit einem gemessenem Phasenunterschied 0̸ = 0 ist.

In FIG 5b muß dagegen die positive Flanke des Istimpulses A nach dem Festhalten beim Herausschieben nur noch zehn Laufzeitglieder 1 durchlaufen. Dies sind zwei Laufzeitglieder 1 weniger als bei der Phasendifferenz 0̸ = 0, womit die Auswerteschaltung 12 einen Phasenunterschied von +2/8 T detektiert. Sind dagegen beispielsweise noch sechzehn Laufzeitglieder 1 zu durchlaufen, wie in FIG 5c gezeigt, so sind dies vier Laufzeitglieder 1 mehr als bei der Phasendifferenz 0, womit eine Phasendifferenz von -4/8 T vorliegt. In den FIG 5d und 5e sind noch die Lagen der Istimpulse A in der Laufzeitkette 2 bei Phasendifferenzen 0̸ von +3/8 T bzw. -5/8 T dargestellt.

Das erfindungsgemäße Verfahren und die vorgestellten Schaltungsanordnungen zur Durchführung des Verfahrens können bevorzugt in Fernsehgeräten mit einem digitalen Phasenregelkreis zur Steuerung der Einblendung eines ersten Bildes in ein zweites Bild eingesetzt werden. Darüber hinaus ist es möglich, das Verfahren in einem Fernsehgerät mit einem digitalen Phasenregelkreis zur Erzeugung eines zeilenverkoppelten Taktes zu verwenden, da es dort auch auf das Erfassen kleiner Phasendifferenzen im Phasendetektor des Phasenregelkreises ankommt.

## Patentansprüche

1. Verfahren zum Messen kleiner Phasendifferenzen (0̸) zwischen einem Istimpuls (A) und einem Referenzimpuls (B),
**dadurch gekennzeichnet,**
daß der Istimpuls (A) in eine aus einer Vielzahl von Laufzeitgliedern (1) bestehende Laufzeitkette (2) läuft,
daß der Istimpuls (A) nach Maßgabe eines Steuersignales (3) in der Laufzeitkette (2) festgehalten wird,
daß die Lage des Istimpulses (A) in der Laufzeitkette (2) durch taktgesteuertes Herausschieben ermittelt wird
und daß die Anzahl der dabei noch zu durchlaufenden Laufzeitglieder (1) die Phasendifferenz (0̸) bestimmt.

2. Verfahren nach Anspruch 1,
**dadurch gekennzeichnet,**
daß für jedes Laufzeitglied (1) eine Laufzeit (d) gewählt wird, die kleiner als 1/10 einer Taktperiode (T) des Referenzimpulses (B) ist.

3. Verfahren nach Anspruch 2,
**dadurch gekennzeichnet,**
daß die Laufzeit (d) kleiner als 3 nsec gewählt wird.

4. Verfahren nach einem der Ansprüche 1 bis 3,
**dadurch gekennzeichnet,**
daß die Messung kleiner Phasendifferenzen (0̸) erst dann aktiviert wird, wenn eine Grobphasenmessung mit der Auflösung einer Taktperiode (T) einen vorgegebenen Phasendifferenzwert unterschreitet.

5. Schaltungsanordnung zur Durchführung des Verfahrens nach einem der Ansprüche 1 bis 4,
**gekennzeichnet** durch folgende Merkmale:
- eine Laufzeitkette (2) mit einer Vielzahl von hintereinandergeschalteten Laufzeitgliedern (1),
- zwischen eine Eingangsklemme (3) und eine Ausgangsklemme (4) jedes Laufzeitgliedes (1) ist die Reihenschaltung einer Laststrecke eines ersten Transistors (5), eines ersten Inverters (6), eine Laststrecke eines zweiten Transistors (7) sowie ein zweiter Inverter (8) angeordnet,
- eine Steuereinrichtung (9), die mit Steueranschlüssen (10, 11) der ersten und zweiten Transistoren (5, 7) verbunden ist sowie
- eine Auswerteschaltung (12), die ausgangsseitig an die Laufzeitkette (2) geschaltet ist.

6. Schaltungsanordnung nach Anspruch 5,
**dadurch gekennzeichnet,**
daß die Laufzeitkette so ausgebildet ist, daß eine Laufzeitverzögerung von mindestens drei Taktperioden (T) möglich ist.

7. Schaltungsanordnung nach Anspruch 5 oder 6,
**dadurch gekennzeichnet,**
daß zum Einlaufen des Istimpulses (A) in die Laufzeitkette (2) alle ersten und zweiten Transistoren (5, 7) durch die Steuereinrichtung (9) gemeinsam einschaltbar und zum Herausschieben des Istimpulses (A) abwechselnd einschaltbar sind.

8. Verwendung des Verfahrens nach einem der Ansprüche 1 bis 4 in einem Fernsehgerät mit einem digitalen Phasenregelkreis zur Steuerung der Einblendung eines ersten Bildes in ein zweites Bild.

9. Verwendung des Verfahrens nach einem der Ansprüche 1 bis 4 in einem Fernsehgerät mit einem digitalen Phasenregelkreis zur Erzeugung eines zeilenverkoppelten Taktes.

## Claims

1. Method for measuring small phase differences (φ) between an actual pulse (A) and a reference pulse (B), characterized in that the actual pulse (A) passes into a delay line (2) comprising a plurality of delay elements (1), in that the actual pulse (A) is stopped in the delay line (2) as a function of a control signal (3), in that the position of the actual pulse (A) in the delay line (2) is determined by clock-controlled shifting outward, and in that the number of delay elements (1) remaining to be traversed determines the phase difference (φ).

2. Method according to Claim 1, characterized in that for each delay element (1) a transit time (d) is selected which is smaller than 1/10 of a clock period (T) of the reference pulse (B).

3. Method according to Claim 2, characterized in that the transit time (d) is selected to be smaller than 3 nsec.

4. Method according to one of Claims 1 to 3, characterized in that the measurement of small phase differences (φ) is activated only when a coarse phase measurement with the resolution of one clock period (T) falls below a predetermined phase difference value.

5. Circuit arrangement for carrying out the method according to one of Claims 1 to 4, characterized by the following features:
- a delay line (2) comprising a plurality of series-connected delay elements (1),
- the series circuit of a load path of a first transistor (5), a first invertor (6), a load path of a second transistor (7) and a second invertor (8) is disposed between an input terminal (3) and an output terminal (4) of each delay element (1),
- a control device (9), which is connected to control connections (10, 11) of the first and second transistors (5, 7), and
- an evaluating circuit (12), which is connected on the output side to the delay line (2).

6. Circuit arrangement according to Claim 5, characterized in that the delay line is designed so that a transit time delay of at least three clock periods (T) is possible.

7. Circuit arrangement according to Claim 5 or 6, characterized in that for the entry of the actual pulse (A) into the delay line (2) all first and second transistors (5, 7) are energizable in common by the control device (9) and for the shifting outward of the actual pulse (A) they are energizable in alternation.

8. Use of the method according to one of Claims 1 to 4 in a television system having a digital phase-locked loop for the control of the feeding in of a first picture into a second picture.

9. Use of the method according to one of Claims 1 to 4 in a television system having a digital phase-locked loop for the generation of a line-coupled clock.

## Revendications

1. Procédé pour la mesure de faibles différences (0̸) de phase entre une impulsion réelle (A) et une impulsion (B) de référence,
caractérisé en ce que
l'impulsion réelle (A) transite dans une ligne (2) retard, constituée d'un grand nombre d'éléments (1) à retard,
l'impulsion réelle (A) est maintenue dans la ligne à retard en fonction d'un signal (3) de commande,
la position de l'impulsion réelle (A) dans la ligne à retard est déterminée par extraction cadencée,
et le nombre d'éléments (1) à retard restant encore à parcourir à cet instant détermine la différence (0̸) de phase.

2. Procédé selon la revendication 1,
caractérisé en ce que
pour chaque élément (1) à retard, on choisit un retard (d) de parcours, qui est inférieur à 1/10 d'une période (T) de cadencement de l'impulsion (B) de référence.

3. Procédé selon la revendication 2,
caractérisé en ce que
l'on choisit le retard (d) de parcours plus petit que 3 nsec.

4. Procédé selon l'une des revendications 1 à 3,
caractérisé en ce que
la mesure de petites différences (0̸) de phase n'est activée que lorsqu'une mesure grossière de phase devient inférieure à une valeur de différence de phase prescrite, pour la résolution d'une période (T) de cadencement.

5. Circuit pour mettre en oeuvre le procédé selon l'une des revendications 1 à 4,
caractérisé par les caractéristiques suivantes :
- une ligne (2) à retard comportant un grand nombre d'éléments (1) à retard placés à la suite les uns des autres,
- entre une borne (3) d'entrée et une borne (4) de sortie de chaque élément (1) à retard est disposé le circuit série d'une section de charge formée d'un premier transistor (5), d'un premier inverseur (6), une section de charge formée d'un deuxième transistor (7), ainsi qu'un deuxième inverseur (8),
- un dispositif (9) de commande, qui est connecté à des bornes (10, 11) de commande du premier et du deuxième transistors (5, 7), et aussi
- un circuit (12) d'exploitation, qui est branché côté sortie à la ligne
(2) à retard.

6. Dispositif de circuit selon la revendication 5,
caractérisé en ce que
- la ligne à retard a une configuration telle, qu'un retard total de parcours d'au moins trois périodes (T) de cadencement est possible.

7. Circuit selon la revendication 5 ou 6,
caractérisé en ce que
pour introduire l'impulsion réelle (A) dans la ligne (2) à retard, tous les premiers et deuxièmes transistors (5, 7) peuvent être mis en marche en commun par le dispositif (9) de commande et peuvent être mis en marche alternativement, pour extraire l'impulsion réelle (A).

8. Utilisation du procédé selon l'une des revendications 1 à 4 dans un appareil de télévision, comportant un circuit numérique à verrouillage de phase destiné à commander l'incrustation d'une première image dans une deuxième image.

9. Utilisation du procédé selon l'une des revendications 1 à 4 dans un appareil de télévision, comportant un circuit numérique à verrouillage de phase destiné à produire un cadencement couplé aux lignes.
